# Europäisches Patentamt

# European Patent Office

# Office européen des brevets

(19)

(11) Veröffentlichungsnummer: **0 052 739**
**B1**

(12)

# EUROPÄISCHE PATENTSCHRIFT

(45) Veröffentlichungstag der Patentschrift:
05.02.86

(51) Int. Cl.⁴: **H 01 L 31/10**

(21) Anmeldenummer: **81108178.5**

(22) Anmeldetag: **09.10.81**

(54) **Fototransistor.**

(30) Priorität: **25.11.80 DE 3044341**

(43) Veröffentlichungstag der Anmeldung:
**02.06.82 Patentblatt 82/22**

(45) Bekanntmachung des Hinweises auf die Patenterteilung:
**05.02.86 Patentblatt 86/6**

(84) Benannte Vertragsstaaten:
**CH DE FR GB IT LI SE**

(56) Entgegenhaltungen:
**DE - A - 2 130 457**
**DE - A - 2 922 250**
**US - A - 3 405 329**

**IBM TECHNICAL DISCLOSURE BULLETIN, Band 19, Nr. 11, April 1977, New York, S.G. CHAMBERLAIN "High speed scanner photoelement with gain", Seiten 4458 bis 4460**

(73) Patentinhaber: **Siemens Aktiengesellschaft, Berlin und München Wittelsbacherplatz 2, D-8000 München 2 (DE)**

(72) Erfinder: **Baumgartner, Werner, Rossinistrasse 12, D-8000 München 40 (DE)**
Erfinder: **Krockow, Dieter, Ing.-grad., Conollystrasse 28, D-8000 München 40 (DE)**
Erfinder: **Tihany, Jenö, Dr. Ing., Wolfratshauser Strasse 179 a, D-8000 München 71 (DE)**

**0 052 739**

## Beschreibung

Die Erfindung bezieht sich auf einen Fototransistor mit einem Halbleiterkörper, der auf seiner einen Oberfläche einen zur Belichtung bestimmten Bereich aufweist, mit einer Kollektorzone, in die planar eine Basiszone eingelagert ist, mit einer Emitterzone, die planar in die Basiszone eingelagert ist, mit einer Emitterelektrode und einer den zur Belichtung bestimmten Bereich bedeckenden Isolierschicht, mit einer in die Oberfläche eingelagerten Hilfszone des der Kollektorzone entgegengesetzten Leitungstyps, und mit einer auf der Isolierschicht angeordneten Hilfselektrode, die den an die Oberfläche tretenden Teil der Basiszone und die Hilfszone zumindest überlappt und den an die Oberfläche tretenden Teil der Kollektorzone bedeckt.

Ein solcher Fototransistor ist bereits Gegenstand einer älteren nationalen Anmeldung DE-A- 29 22 250. Die erwähnte Hilfselektrode überdeckt dort den an die Oberfläche tretenden Teil von Basiszone und Kollektorzone und überlappt die Hilfszone. Wird an die Hilfselektrode eine Spannung gelegt, so verformt sich bei angelegter Emitter-Kollektorspannung die Raumladungszone. Damit stellen sich Äquipotentialflächen ein, die die in der Raumladungszone durch Lichteinwirkung erzeugten Träger dazu zwingen, zur p-Basiszone des Fototransistors zu fließen. Andererseits verhindert diese Form der Raumladungszone, daß außerhalb des Fototransistors zum Beispiel in anderen Funktionsstrukturen einer integrierten Schaltung erzeugte Ladungsträger zur. Basiszone des Fototransistors fließen.

Aus IBM Techn. Discl. Bull., Vol. 19, No.11, Aprill 1977 S. 4458-4460 ist eine Fototransistor bekannt, der ähnlich aufgebaut ist wie der oben genannte Fototransistor. Jedoch über deckt die erwähnte Hilfselektrode bei diesem bekannten Fototransistor die Kollektorzone nur teilweise und überlappt zwar die Basiszone, ohne aber die Hilfszone zu überlappen. Durch diese Struktur der Hilfselektrode wird bei dem bekannten Fototransistor nicht sichergestellt, daß alle durch Lichteinwirkung erzeugten Ladungsträger zwangsweise zur Basiszone fließen.

Der Erfindung liegt die Aufgabe zugrunde, einen Fototransistor der oben erwähnten Art so weiterzubilden, daß eine ähnlich gute oder noch bessere Abschirmwirkung durch die Hilfselektrode auch dann erreicht wird, wenn die Fläche des Fototransistors klein gegen die Fläche der Emitter- und Basiszone ist.

Die Erfindung ist dadurch gekennzeichnet, daß die Isolierschicht am Rand des zur Belichtung bestimmten Bereichs und über der Hilfszone dicker als über dem Bereich ist, daß die Hilfselektrode über dem dickeren und über dem dünneren Teil der Isolierschicht liegt, und daß der dickere Teil die Hilfszone überlappt.

Weiterbildungen der Erfindung sind Gegenstand der Unteransprüche.

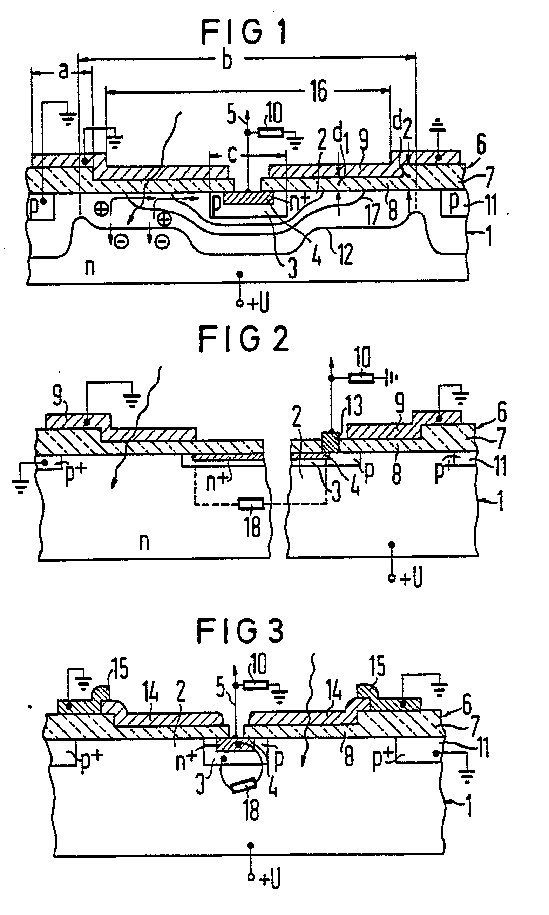

Die Erfindung wird an Hand von vier Ausführungsbeispielen in Verbindung mit den Fig. 1 bis 3 näher erläutert. Gleiche oder funktionsgleiche Teile sind mit gleichen Bezugszeichen versehen.

In Fig. 1 ist der Halbleiterkörper 1 eines Fototransistors im Schnitt dargestellt. Er hat eine Kollektorzone 2, in die eine Basiszone 3 planar eingebettet ist. In die Basiszone 3 ist eine Emitterzone 4 ebenfalls planar eingebettet. Alle drei Zonen treten daher an die Oberfläche des Halbleiterkörpers 1. Die genannten Zonen haben beispielsweise die Zonenfolge npn+. Der Emitter 4 ist über eine nicht näher bezeichnete Emitterelektrode mit einem Anschluß 5 verbunden, der den Ausgang des Fototransistors darstellt. Der Ausgang 5 liegt über einen Widerstand 10 an Massepotential. In die Oberfläche ist außerdem eine Hilfszone 11 eingebettet, die der Kollektorzone 2 entgegengesetzten Leitungstyp hat. Sie kann auf Massepotential liegen oder einige Volt negativ vorgespannt sein. Die Oberfläche des Halbleiterkörpers 1 ist mit einer Isolierschicht 6 bedeckt, die zum Beispiel aus Siliciumdioxid SiO besteht. Diese Isolierschicht hat einen dünnen Teil 8 und einen dickeren Teil 7. Der dickere Teil 7 überlappt die Hilfszone 11. Die Dicke $d_1$ des dünneren Teils 8 kann 50 bis 300 nm und die Dicke $d_2$ des dickeren Teils 7 kann SOO bis 1500 nm betragen. Die Ausdehnung des dünneren Teils 8 stimmt etwa mit der Ausdehnung des zur Belichtung bestimmten Bereichs 16 überein. Der Rand des zur Belichtung bestimmten Bereichs ist durch den dickeren Teil 7 der Isolierschicht 6 gebildet. Auf dem dicken Teil 7 und dem dünnen Teil 8 der Isolierschicht 6 ist eine Hilfselektrode 9 angeordnet, die zum Beispiel aus n-dotiertem polykristallinem Silicium besteht. Diese Hilfselektrode kann an einer Hilfsspannung oder auf Massepotential liegen.

Wird der Kollektor an positives Potential gelegt, so bildet sich zwischen der Oberfläche des Halbleiterkörpers und der Kollektorzone beziehungsweise zwischen dem zwischen den Zonen 2 und 3 liegenden pn-Übergang und der Kollektorzone eine Raumladungszone aus, deren Grenze mit 12 bezeichnet ist. Die Grenze 12 der Raumladungszone folgt dabei von außen nach innen etwa der Form der Hilfselektrode 9. Etwa im Bereich des Übergangs von der Dicke $d_2$ auf die Dicke $d_1$ hat die Breite der Raumladungszone ein Minimum. Unter der Basiszone 3 hat sie den größten Abstand zur Oberfläche. Durch die Form der Raumladungszone stellt sich eine ähnliche Form der Äquipotentiallinien 17 ein.

Wird nun in den zur Belichtung bestimmten Bereich Licht mit der Energie h.ʋ eingestrahlt, so werden in der Raumladungszone Ladungsträgerpaare erzeugt. Die positiven Ladungsträger fließen zunächst auf die Oberfläche des Halbleiterkörpers zu und dann lateral zur Basiszone 3. Auf diese Weise wird vermieden, daß durch Lichteinfall erzeugte Ladungsträger zu anderen Funktionsstrukturen abfließen und nicht zur Basiszone 3 gelangen. Gleichfalls wird vermieden, daß in anderen Funktionseinheiten außerhalb des Fototransistors erzeugte Ladungsträger zur Basiszone 3 fließen.

Beim beschriebenen Fototransistor kann die Fläche der Basiszone 3 klein gegenüber der Fläche des zur Belichtung bestimmten Bereichs 16 gemacht werden, da auch nahe des Randes des Bereichs 16 erzeugte Ladungsträger in lateraler Hichtung zur Basiszone 3 fließen. Eine solche Anordnung kann mit Vorteil zum Ansteuern von LeistungsMOS-Bauelementen verwendet werden, da die Basis-Kollektor-Kapazität des Fototransistors durch die kleine Basiszonenfläche sehr klein gehalten werden kann. Diese Kapazität liegt nämlich einer der Eingangskapazitäten des Leistungs-MOS-Bauelements parallel und muß im Interesse aines guten

2

# 0 052 739

Schaltverhaltens des MOS-Bauelements klein sein. Als brauchbar hat sich zum Beispiel eine Lateralabmessung c der Basiszone 3 von 10 bis 40 μm gegenüber einer Lateralabmessung b der Kollektorzone von 200 bis 1000 μm erwiesen. Die Lateralabmessung des dickeren Teils 7 der Isolierschicht 6 kann zwischen 10 und 50 μm liegen.

Ein anderes Ausführungsbeispiel ist in Fig. 2 dargestellt, das sich von dem nach Fig. 1 dadurch unterscheidet, daß die Emitterelektrode 13 auf der Seite einer relativ breiten Emitterzone sitzt. Sie kontaktiert gleichzeitig auch den Rand der Basiszone 3.

Die p-Basis ist ebenfalls relativ breit und bildet einen Widerstand, der symbolisch dargestellt und mit 18 bezeichnet ist. Dieser Widerstand ist dann vorteilhaft, wenn der Fototransistor in mit höheren Sperrspannungen betriebenen Bauelementen verwendet wird.

Im Ausführungsbeispiel nach Fig. 3 ist die Hilfselektrode gegenüber den Ausführungsbeispielen nach Fig. 1 und 2 abgewandelt. Die Hilfselektrode besteht aus zwei Teilen 14, 15, von denen das Teil 14 über dem dünneren Teil 8 der Isolierschicht 6 und das Teil 15 über dem dickeren Teil 7 liegt. Das Teil 15 besteht hier aus einem Metall, zum Beispiel aus Aluminium, während das Teil 14 wegen seiner Durchlässigkeit für Licht aus dotiertem Polysilicium besteht. Beide Hilfselektrodenteile sind elektrisch dadurch miteinander verbunden, daß das Teil 14 über die Stufe reicht und dort von dem Metall kontaktiert ist. Für höhere Sperrspannungen kann zwischen der Emitterzone 4 und der Basiszone 3 wie in Fig. 2 noch der Widerstand 18 liegen. Dieser ist in Fig. 3 lediglich symbolisch dargestellt.

## Patentansprüche

1. Fototransistor mit einem Halbleiterkörper (1), der auf seiner einen Oberfläche einen zur Belichtung bestimmten Bereich (16) aufweist, mit einer Kollektorzone (2) in die planar eine Basiszone (3) eingelagert ist, mit einer Emitterzone (4), die planar in die Basiszone eingelagert ist, mit einer Emitterelektrode (13) und einer den zur Belichtung bestimmten Bereich (16) bedeckenden Isolierschich (6), mit einer in die Oberfläche eingelagerten Hilfszone (11) des der Kollektorzone (2) entgegengesetzten Leitungstyps, und mit einer auf der Isolierschicht (6) angeordneten Hilfselektrode (3), die den an die Oberfläche tretenden Teil der Basiszone (3( und die Hilfszone (11) zumindest überlappt und den an die Oberfläche tretenden Teil der Kollektorzone (2) bedeckt, da- durch gekennzeichnet, daß die Isolierschicht (6) am Rand des zur Belichtung bestimmten Bereichs und über der Hilfszone (11) dicker als über dem Bereich (16) ist, daß die Hilfselektrode (9) über dem dickeren und über dem dünneren Teil (17u. 8) der Isolierschicht (6) liegt, und daß der dickere Teil (7) die Hilfszone (11) überlappt.

2. Fototransistor nach Anspruch 1, dadurch gekennzeichnet, daß die Hilfselektrode(9) mindestans über dem dünneren Teil (8) der Isolierschicht (6) aus Polysilicium besteht.

3. Fototransistor nach Anspruch 1 oder 2, da- durchgekennzeichnet, daß die Emitterzone (4) und die Basiszone (3) breit gegen die Emitterelektrode (13) ist, und daß die Emitterelektrode den Rand der Basiszone (3) kontaktiert.

4. Fototransistor nach einem der vorhergehenden Ansprüche, dadurch gekennzeichnet, daß die Fläche des zur Belichtung bestimmten Bereichs (16) 300 bis 800 mal größer als die Fläche der Basiszone (3) ist.

## Claims

1. A photo-transistor comprising a semiconductor body (1), which on one surface has a region (16) which is intended to be illuminated, comprising a collector zone (2) in which a base zone (3) is embedded in planar fashion, an emitter zone (4) which is embedded in the base zone in planar fashion, an emitter electrode (13), an insulating layer (6) covering the region (16) intended to be illuminated, an auxiliary zone (11) of the opposite conductivity type to that of the collector zone (2) embedded in the surface, and an auxiliary electrode (19) arranged on the insulating layer (6) and which overlaps at lesst the part of the base zone (3), which appears at the surface and the auxiliary zone (11), and covers the part of the collector zone (2) which appesrs at the surface, characterised in that, at the edge of the region which is intended to be illuminated and above the auxiliary zone (11), the insulating layer (6) is thicker than above the region (16); that the auxiliary electrode (9) is arranged above the thicker and above the thinner part (7 and 8) of the insulating layer (6); and thst the thicker part (7) overlaps the auxiliary zone (11).

2. A photo-transistor as claimed in Claim 1, characterised in that the auxiliary electrode (9) consists of polysilicon, at least above the thinner part (8) of the insulating layer (6).

3. A photo-transistor as claimed in Claim 1 or Claim 2, characterised in that the emitter zone (4) and the base zone (3) are wide compared with the emitter electrode (13); and that the emitter electrode (13) contacts the edge of the base zone (3).

4. A photo-transistor as claimed in one of the preceding Claims, characterised in that the surface of the region (16) which is intended to be illuminated, is 300 to 800 times larger than the surface of the base zone (3).

**Revendications**

1. Phototransistor avec un corps semiconducteur (1) qui comporte sur l'une de ses surfaces une zone (16) destinée à être éclairée, avec une zone de collecteur (2) dans laquelle est incorporée une zone de base planar (3), avec une zone d'émetteur (4), incorporee de façon planar dans la zone de base, avec une électrode d'émetteur (13) et une couche isolante (6) recouvrant la zone (16) destinée à être éclairee, avec une zone auxiliaire (11) du type de conductibilité opposée à celle de la zone de collecteur (2), et incorporée dans la surface, avec une électrode auxiliaire (9) disposée sur la couche isolante (6), qui chevauche la partie de la zone de base (3) apparaissant à la surface et qui recouvre la partie de la zone de collecteur (2) qui apparaît à la surface, caractérisé par le fait que la couche isolante (6) est, au bord de la zone destinée à être éclairée et sur la zone auxiliaire (11), plus épaisse que sur la zone (16), que l'électrode auxiliaire (9) se situe sur la partie plus épaisse et sur la partie plus mince (7 et 8) de la couche isolante (6), et que la partie plus épaisse (7) chevauche la zone auxiliaire (11).

2. Phototransistor selon la revendication 1, caractérisé par le fait que l'électrode auxiliaire (9) est constituée, au moins au-dessus de la partie plus mince (8) de la couche isolante (6), par du polysilicium.

3. Phototransistor selon la revendication 1 ou 2, caractérisé par le fait que la zone d'émetteur (4) et la zone de base (3) sont larges par rapport à l'électrode d'émetteur (13) et que l'électrode d'émetteur (13) contacte le bord de la zone de base (3).

4. Phototransistor selon l'une des revendications précédentes, caractérisé par le fait que la surface de la zone qui est destinée à être éclairée (16) est de 300 à 800 fois plus grande que la surface de la zone de base (3).

FIG 1

FIG 2

FIG 3